# FASCICULE DE BREVET EUROPEEN

(11) **EP 1 101 193 B1**
(45) Date de publication et mention de la délivrance du brevet: **05.06.2002**
(21) Numéro de dépôt: 99929418.4
(22) Date de dépôt: 06.07.1999
(51) Int. Cl.: G06K 19/077

(54) **ANTENNE AJOUREE POUR CARTE A CIRCUIT INTEGRE, ET CARTE A CIRCUIT INTEGRE COMPRENANT UNE TELLE ANTENNE**
PERFORIERTE ANTENNE FÜR IC KARTE UND IC KARTE MIT SOLCHER ANTENNE
OPEN-WORKED ANTENNA FOR INTEGRATED CIRCUIT CARD, AND INTEGRATED CIRCUIT CARD COMPRISING SAME

(30) Priorité: 06.07.1998 FR 9808604
(43) Date de publication de la demande: 23.05.2001
(73) Titulaire: SCHLUMBERGER Systèmes, 92120 Montrouge (FR)
(72) Inventeur: FLETOUT, Christophe, F-45760 Boigny sur Bionne (FR); THEVENOT, Benoît, F-45160 Olivet (FR); BREL, Marie-Cécile, F-45000 Orléans (FR); LETOURNEL, Jean-Luc, F-45160 Olivet (FR); BORG, Norbert, F-45240 La Ferté Saint Aubin (FR); DUPUIS, Nathalie, F-45380 Chaingy (FR); MANDE, Mickael, F-45100 Orléans (FR)
(74) Mandataire: Macquet, Christophe
(86) Numéro de dépôt international: FR9901633
(87) Numéro de publication internationale: WO0002160

(56) Documents cités:
- WO-A-97/05569
- DE-A- 19 640 260

## Description

La présente invention concerne une antenne pour carte à circuit intégré et une carte à circuit intégré comportant une telle antenne. Les cartes de ce type peuvent être reliées à un lecteur par une liaison sans contact par couplage magnétique ou hertzien.

Selon un mode de réalisation bien connu, une carte de ce type comprend un corps de carte en matériau isolant dans lequel est noyée une antenne ayant des extrémités constituées par des couches conductrices formant des bornes de connexion, et un module à circuit intégré reçu dans une cavité du corps de carte et pourvu de plages de connexion interne reliées aux bornes de connexion de l'antenne.

L'antenne est généralement noyée dans le corps de carte lors d'une opération de laminage, c'est-à-dire que l'antenne est disposée entre deux couches du corps de carte qui sont chauffées et pressées l'une contre l'autre.

Or, il s'avère que le matériau isolant constituant le corps de carte adhère difficilement au cuivre constituant les bornes de connexion. Il en résulte une mauvaise cohésion du corps de carte au niveau des bornes de connexion de l'antenne, ce qui limite la résistance mécanique de la carte. Cette mauvaise cohésion est d'autant plus importante que la surface des bornes de connexion est grande. Il n'est cependant pas souhaitable de réduire cette surface car une surface relativement importante permet de faciliter le positionnement du module à circuit intégré par rapport aux bornes de connexion de l'antenne.

Pour remédier à ce problème, on a donc pensé à recouvrir les bornes de connexion d'un adhésif. L'amélioration de la cohésion du coprs de carte apportée par l'adhésif est toutefois insuffisante pour conférer à la carte la résistance mécanique recherchée.

Il convient de noter que la demande de brevet DE-A-19640260 décrit certes une antenne pour carte à circuit intégré possédant une piste conductrice formant au moins une spire et des extrémités dans chacune desquelles est formé un trou. Mais le but du trou n'est pas le même que celui des jours dans la présente invention. Dans DE-A-19640260, chaque trou sert à faire passer le bout d'un contact d'un cadre conducteur dans le trou avant de le fixer à l'aide d'un point de soudure à une extrémité de l'antenne. Par conséquent, ce document ne suggère en aucun cas de former plusieurs jours dans les extrémités de l'antenne.

Un but de l'invention est de fournir un moyen pour assurer une bonne cohésion du corps de carte au niveau des bornes de connexion de l'antenne sans réduire la surface de celles-ci.

En vue de la réalisation de ce but, on prévoit, selon l'invention, une antenne pour carte à circuit intégré, comprenant une piste conductrice formant au moins une spire et ayant des extrémités comprenant des bornes de connexion, caractérisée en ce que les bornes de connexion et/ou la piste conductrice présentent chacune des trous.

Ainsi, lors du laminage de l'antenne et du corps de carte, le matériau du corps de carte s'étendant de part et d'autre des bornes de connexion flue au travers des jours des bornes de connexion et/ou de la piste conductrice et se soude sur lui-même dans ces jours. La cohésion du corps de carte au niveau des bornes de connexion et/ou de la piste conductrice de l'antenne est alors élevée et la résistance mécanique de la carte améliorée.

Selon un mode de réalisation particulier, lesdits jours des bornes de connexion comportent des lumières en forme de bandes. Cette forme des lumières permet d'obtenir une section de passage importante du matériau constituant le corps de carte au travers des jours des bornes de connexion de l'antenne, tout en préservant une surface conductrice suffisante pour permettre une bonne liaison électrique avec le module à circuit intégré de la carte.

Avantageusement alors, les lumières ont un contour ondulé.

Le risque d'une rupture des bornes de connexion et/ou de la piste conductrice de l'antenne lors de l'application d'un effort à la carte est ainsi minimisé quelle que soit la direction de cet effort.

L'invention concerne également une carte à circuit intégré telle que définie à la revendication 5.

D'autres caractéristiques et avantages de l'invention apparaîtront à la lecture de la description qui suit d'un mode de réalisation particulier non limitatif de l'invention.

Il sera fait référence aux dessins annexés, parmi lesquels :
- la figure 1 est une vue partielle en coupe d'une carte à connexion mixte selon l'invention ;
- la figure 2 est une vue de dessus d'une antenne conforme à l'invention ;
- la figure 3 est une vue partielle d'une antenne selon un premier mode de réalisation de l'invention ;
- la figure 4 est une vue analogue à la figure 3 d'une antenne selon un deuxième mode de réalisation ;
- la figure 5 est une vue analogue à la figure 4 d'une antenne selon une variante du deuxième mode de réalisation ;
- la figure 6 est une vue partielle d'une antenne selon un autre mode de réalisation de l'invention ; et
- les figures 7A, 7B, 7C et 7D sont des vues partielles de différents modes de réalisation d'une piste conductrice d'antenne selon l'invention.

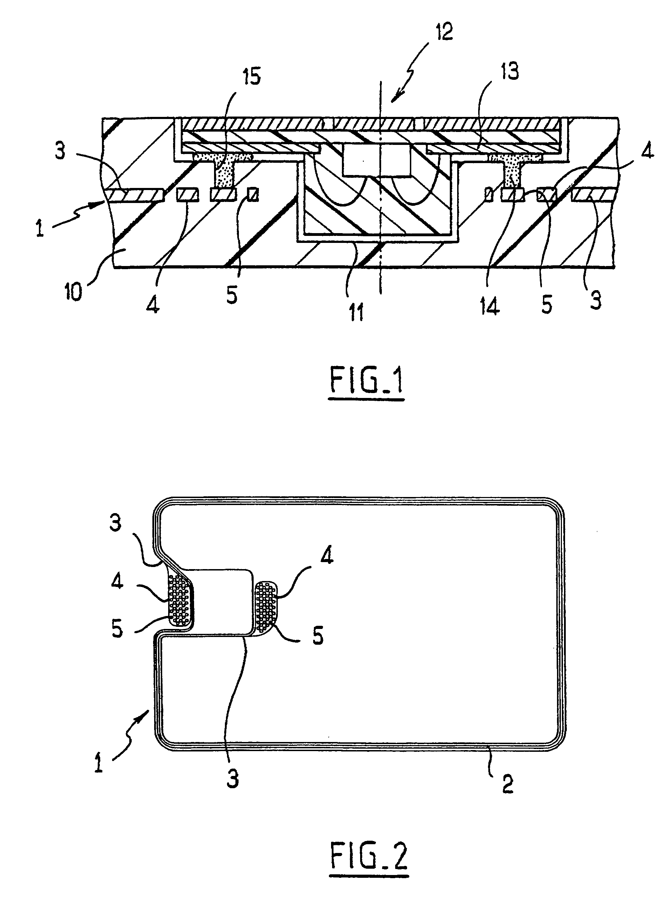

En référence à la figure 2, une antenne généralement désignée en 1 comprend de façon connue en soi une piste conductrice 2 en cuivre formant des spires et ayant des extrémités 3. Chaque extrémité 3 comprend une couche conductrice formant une borne de connexion 4.

Selon l'invention, les bornes de connexion 4 présentent plusieurs jours.

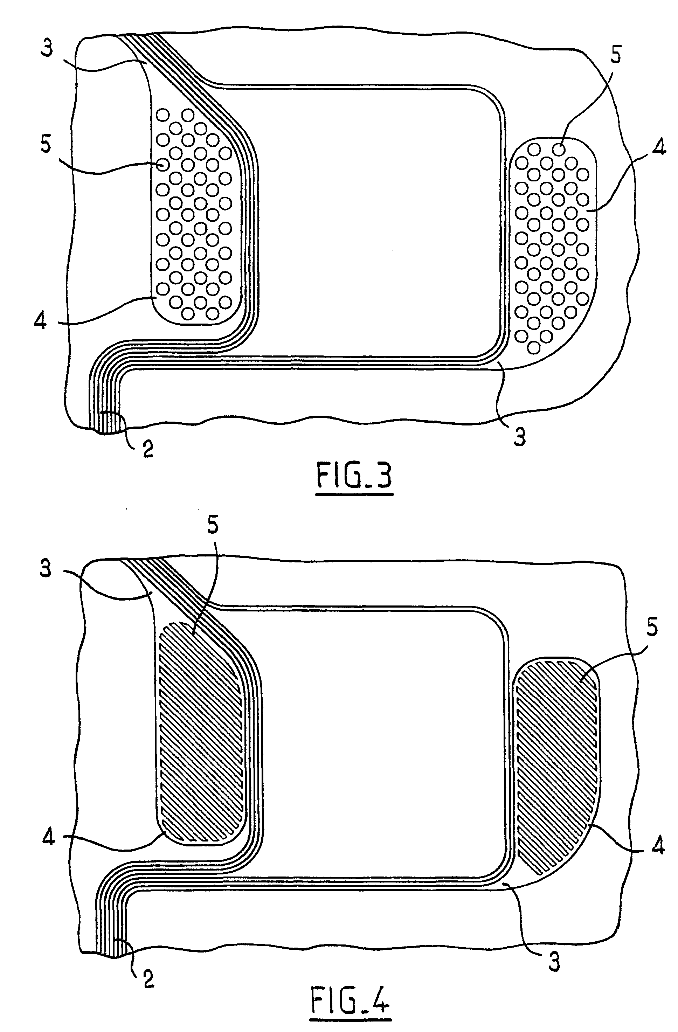

En référence plus particulièrement à la figure 3, et selon un premier mode de réalisation, les jours des bornes de connexion 4 sont formés d'un réseau de trous circulaires 5 régulièrement répartis sur toute la surface des bornes de connexion.

En référence à la figure 4, et selon un deuxième mode de réalisation, les jours sont formés par des lumières 5 en forme de bandes rectilignes. Les lumières sont parallèles les unes aux autres et sont régulièrement réparties sur toute la surface de chaque borne de connexion 4.

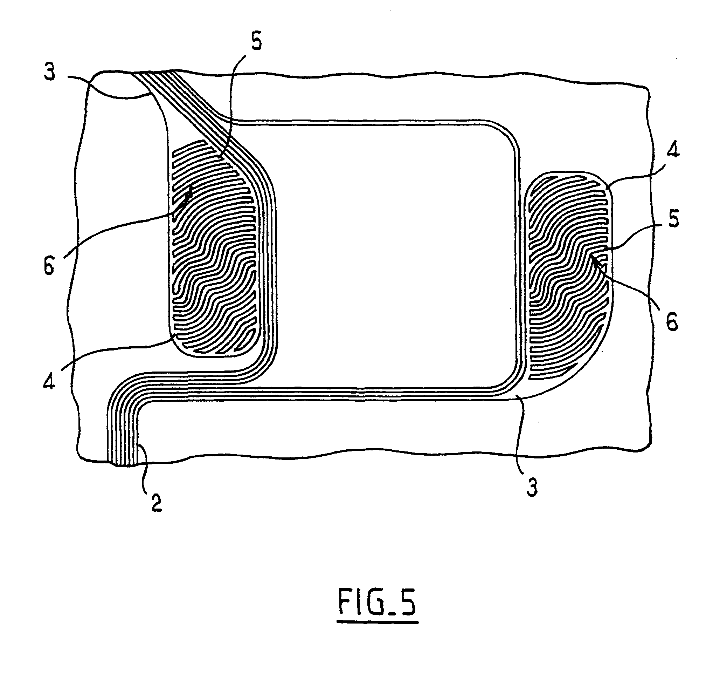

En variante, et selon la figure 5, les jours sont formés par des lumières 5, ayant la forme de bandes dont le contour 6 est ondulé.

En référence à la figure 1, la carte à circuit intégré selon l'invention, ici une carte à connexion mixte, comprend un corps de carte 10 en matériau isolant tel que du polychlorure de vinyle.

Une antenne 1 identique à celle de la figure 2 décrite précédemment est noyée dans le corps de carte 10.

Le corps de carte 10 comprend une cavité 11 recevant un module 12 de type connu pourvu de plages de connexion interne. Les plages de connexion interne 13 sont reliées aux bornes de connexion 4 de l'antenne 1 par l'intermédiaire d'une colle conductrice 14, ou par tout autre élément conducteur, reçue dans des perçages 15 s'étendant dans le corps de carte 10 entre les bornes de connexion 4 et les plages de connexion interne 13.

Conformément à l'invention, les bornes de connexion 4 comprennent des jours 5 dans lesquels s'étend le matériau du corps de carte 10 entourant les bornes de connexion 4 de l'antenne 1.

La section des jours 5 sera avantageusement inférieure à la section des perçages 15 de façon qu'un contact optimal puisse être obtenu entre l'élément conducteur reçu dans le perçage 15, ici la colle 14, et la borne de connexion 4, même lorsque le perçage 15 débouche en regard d'un jour 5.

La carte est fabriquée en noyant l'antenne dans le corps de carte 10 par une opération de laminage classique. L'antenne 1 supportée par un film en matériau identique au matériau du corps de carte est disposée entre deux couches du corps de carte qui sont ensuite chauffées puis pressées l'une contre l'autre. On comprend qu'alors, le matériau constituant les couches du corps de carte et le film flue au travers des jours 5 sous l'effet de la pression et se soude sur lui-même dans ces jours.

Bien entendu l'invention n'est pas limitée au mode de réalisation décrit et on peut y apporter des variantes de réalisation sans sortir du cadre de l'invention tel que défini par les revendications.

En particulier, la forme des jours n'est pas limitée à celles décrites précédemment mais recouvre au contraire toute forme adaptée. On peut en outre répartir les jours de façon différenciée sur la surface des bornes de connexion. On peut par exemple ménager un nombre plus important de trous sur la périphérie des bornes qu'au centre de celles-ci.

Bien que l'invention ait été décrite en relation avec une carte à connexion mixte d'une structure particulière, l'invention s'applique à tout type de carte à connexion mixte et à tout type de carte sans contact.

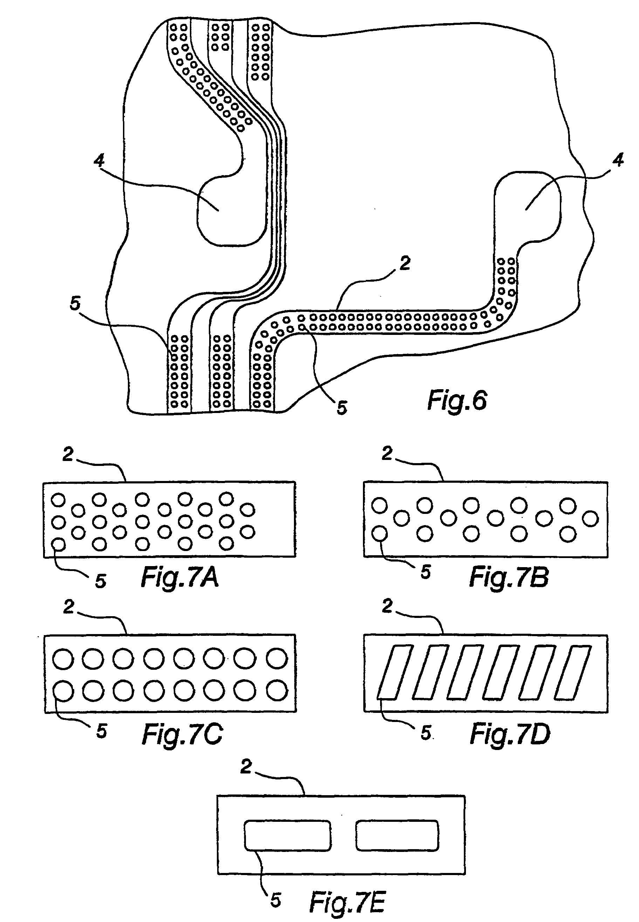

Par ailleurs, ce qui est décrit dans le présent exposé au regard des jours réalisés dans les bornes de connexion 4 est, selon l'invention, applicable à la ligne conductrice 2 formant partie de l'antenne 1. La figure 6 montre un mode de mise en oeuvre de l'invention dans lequel uniquement la piste conductrice est ajourée de jours formant des trous circulaires. Toutefois, ce mode de réalisation n'est nullement limitatif. Les figures 7A à 7E montrent en effet d'autres variantes de réalisation des jours 5. En outre, il est bien entendu que l'antenne selon l'invention peut comporter à la fois des jours dans ses bornes de connexion et dans sa piste conductrice.

Enfin, l'invention montre d'autres avantages. En particulier, les valeurs d'inductance des antennes selon l'invention ne sont pas modifiées par la présence des jours. De surcroît, sachant qu'expérimentalement, une partie métallisée notamment cuivrée contenue dans un corps de carte et qui a une largeur de 0,3 mm laisse une image dite fantôme à la surface de la carte après laminage, cette image fantôme étant essentiellement due à des conditions particulières de fusion puis solidification du plastique constitutif du corps de carte à la verticale des parties métallisées différentes des conditions de fusion puis solidification du plastique dudit corps n'étant pas à la verticale desdites parties, on peut, grâce à l'invention, réaliser une piste bien plus large que 0,3 mm sans que l'image fantôme soit générée à la surface du corps de carte.

## Revendications

1. Antenne pour carte à circuit intégré, comprenant une piste conductrice (2) formant au moins une spire et ayant des extrémités (3) comprenant des couches conductrices formant des bornes de connexion (4), **caractérisée en ce que** les bornes de connexion (4) et/ou la piste conductrice (2) présentent chacune plusieurs jours.

2. Antenne selon la revendication 1, **caractérisée en ce que** lesdits jours des bornes de connexion (4) et/ou de la piste conductrice (2) comportent des lumières en forme de bande.

3. Antenne selon la revendication 2, **caractérisée en ce que** les lumières (5) ont un contour ondulé (6).

4. Antenne selon la revendication 1, **caractérisée en ce que** lesdits jours des bornes de connexion (4) et/ou de la piste conductrice (2) comporte un réseau de trous circulaires (5).

5. Carte à circuit intégré, comprenant un corps de carte (10) en matériau isolant dans lequel est noyée une antenne (1) comprenant une piste conductrice (2) et ayant des extrémités (3) constituées par des couches conductrices formant des bornes de connexion (4), et un module à circuit intégré (12) reçu dans une cavité (11) du corps de carte (10) et pourvu de plages de connexion internes (13) reliées aux bornes de connexion (4) de l'antenne (1), **caractérisée en ce que** les bornes de connexion (4) et/ou la piste conductrice (2) de l'antenne (1) présentent chacune plusieurs jours, le matériau entourant l'antenne s'étendant dans les jours (5) des bornes de connexion (4).

## Patentansprüche

1. Antenne für Karten mit integrierter Schaltung, bestehend aus einer mindestens eine Windung bildende Leiterbahn (2) und Enden (3) mit leitenden Schichten, welche Anschlussklemmen (4) bilden, **dadurch gekennzeichnet, dass** die Anschlussklemmen (4) und/oder die Leiterbahn (2) jeweils mehrere Öffnungen aufweisen.

2. Antenne gemäss Patentanspruch 1, **dadurch gekennzeichnet, dass** besagte Öffnungen der Anschlussklemmen (4) und/oder der Leiterbahn (2) bandförmige Schlitze haben.

3. Antenne gemäss Patentanspruch 2, **dadurch gekennzeichnet, dass** die Schlitze (5) einen gewellten Umriss (6) haben.

4. Antenne gemäss Patentanspruch 1, **dadurch gekennzeichnet, dass** besagte Öffnungen der Anschlussklemmen (4) und/oder der Leiterbahn (2) ein Netz mit kreisförmigen Löchern (5) enthalten.

5. Karte mit integrierter Schaltung, bestehend aus einem Kartenkörper (10) aus Isolierstoff, in welchem eine Antenne (1) implantiert ist, bestehend aus einer Leiterbahn (2) und Enden (3) aus leitenden Schichten, welche Anschlussklemmen (4) bilden sowie einem in einem Hohlraum (11) des Kartenkörpers (10) befindlichen Modul mit integrierter Schaltung (12), und internen Anschlussbereichen (13), welches mit den Anschlussklemmen (4) der Antenne (1) verbunden ist, **dadurch gekennzeichnet, dass** die Anschlussklemmen (4) und/oder die Leiterbahn (2) der Antenne 1 jeweils mehrere Öffnungen aufweisen, wobei das die Antenne umgebende Material in die Öffnungen (5) der Anschlussklemmen (4) fließt.

## Claims

1. Antenna for integrated circuit card, including a conducting track (2) forming at least one turn and whose ends (3) include conducting layers forming connection terminals (4), **characterised in that** the connection terminals (4) and/or the conducting track (2) each have several openings.

2. Antenna according to claim 1, **characterised in that** the said openings in the connection terminals (4) and/or the conducting track (2) include slots in rows.

3. Antenna according to claim 2 **characterised in that** the slots (5) have a wavy outline (6).

4. Antenna according to claim 1, **characterised in that** the said openings in the connection terminals (4) and/or the conducting track (2) include a network of circular holes (5)..

5. Integrated circuit card, including a card body (10) made from insulating material in which is buried an antenna (1) including a conducting track (2) whose ends (3) consisting of conducting layers forming connection terminals (4), and an integrated circuit module (12) placed in a cavity (11) of the card body (10) and equipped with internal connection pads (13) connected to the connection terminals (4) of the antenna (1), **characterised in that** the connection terminals (4) and/or the conducting track (2) of the antenna (1) each have several openings, the material surrounding the antenna spreading through the openings (5) of the connection terminals (4).
